Europäisches Patentamt

(19) European Patent Office

Office européen des brevets

(11) Publication number: **0 106 147**
**A1**

(12) # EUROPEAN PATENT APPLICATION

(21) Application number: **83108962.8**

(22) Date of filing: **10.09.83**

(51) Int. Cl.³: **H 01 L 29/74**
**H 01 L 29/08, H 01 L 29/52**

(30) Priority: **04.10.82 US 432615**

(43) Date of publication of application:
**25.04.84 Bulletin 84/17**

(84) Designated Contracting States:
**DE FR GB**

(71) Applicant: **GENERAL ELECTRIC COMPANY**
**1 River Road**
**Schenectady New York 12305(US)**

(72) Inventor: **Temple, Victor Albert Keith**
**Main Street**
**Clifton Park New York 12065(US)**

(74) Representative: **Voigt, Reinhard, Dipl.-Ing. European**
**Patent Attorney et al,**
**Kaiserstrasse 41**
**D-6000 Frankfurt (Main) 1(DE)**

(54) **Thyristor with turn-off capability.**

(57) A thyristor having a P⁺ emitter region, an N⁻ base region, a P base region, and an N⁺ emitter region includes an anode and a cathode ohmically connected to the P⁺ emitter and N⁺ emitter regions, respectively. A further P⁺ region adjoins the N⁺ emitter region and is ohmically connected to the cathode. Metal-Oxide-Semiconductor ("MOS") turn-off structure having a control electrode is included in the thyristor for transporting holes from the P base region to the further P⁺ region, and thence to the cathode when the control electrode is biased with a voltage below a threshold value in magnitude (e.g., zero volts). Such biasing creates an impediment to turn-on of the thyristor. When the control electrode is biased with a voltage above a threshold value in magnitude, the MOS structure no longer transports holes from the P base region to the further P⁺ region, thereby removing the foregoing impediment to turn-on of the thyristor.

FIG. 1

THYRISTOR WITH TURN-OFF CAPABILITY

Cross-References to Related Applications

The present invention is related to the following U.S. Patent applications,commonly assigned to the instant assignee: Serial No.391,620,filed 24 June 1982; Serial No.345,290,filed 3 February 1982; and Serial No.(Docket RD-14,484),filed contemporaneously herewith; each application having as the sole inventor, V.A.K.Temple. The entire disclosures of the foregoing applications are incorporated herein by reference.

Background of the Invention

The present invention relates to thyristors, and, more particularly, to a thyristor incorporating metal-oxide-semiconductor ("MOS") structure for facilitating turn-off of the thyristor.

Thyristors are four-region (e.g., P-N-P-N) semiconductor devices that are well-known and include an anode and a cathode. A thyristor is turned-on when it provides a high conductance path between its anode and cathode, and is turned-off when it provides a high resistance or non-conducting path between such electrodes. A thyristor typically comprises a $P^+$ (or highly doped P-type) emitter region, an $N^-$ (or lightly doped N-type) base region, a P (or P-type,of a reference doping level) base region, and an $N^+$ emitter region. The above-referenced application Serial No. 391,620, describes and claims such a thyristor which also includes MOS turn-off structure for transporting "holes" (i.e., hole current carriers) from the P base region of the device to the cathode, to thereby turn off the device.

- 2 -

This MOS turn-off structure is effective to transport holes in the foregoing manner only when a control electrode thereof is biased with a voltage whose magnitude exceeds a "threshold" value (i.e., a value at which the state of an MOS structure changes from conducting to non-conducting, or vice-versa). In other words, the MOS turn-off structure is of the normally-off type. The polarity of the foregoing bias voltage is negative with respect to the cathode of the device; hence, it is not readily derivable from the anode-to-cathode voltage of the device. To derive a suitable negative voltage from the anode-to-cathode voltage typically requires the use of complex circuitry with which to generate a negative voltage of pulse form. It would be desirable to avoid the need for such complex circuitry.

A thyristor typically includes turn-on structure including a gate electrode that must be biased with a positive voltage to effectuate device turn-on. When such thyristor also includes MOS turn-off structure, it would be desirable if a single-polarity voltage (positive, here) could bias the control electrodes of both the turn-on structure and the MOS turn-off structure above their respective threshold values.

### Summary of the Invention

Accordingly, it is an object of my invention to provide a thyristor having MOS turn-off structure, wherein a control electrode of such turn-off structure can be biased with a voltage readily derivable from the anode-to-cathode voltage of the thyristor.

A further object of my invention is to provide a thyristor having MOS turn-off structure and a turn-on structure,

-3-

wherein a single-polarity voltage is capable of biasing the control electrodes of both structures above their respective threshold voltages.

In carrying out the objects of my invention in one form, I provide a thyristor including a body of semiconductor material having a $P^+$ emitter region, an $N^-$ base region, a P base region and an $N^+$ emitter region. An anode is ohmically connected to the $P^+$ emitter region, and a cathode is ohmically connected to the $N^+$ emitter region. A further region of P-type conductivity included in the semiconductor body adjoins the $N^+$ emitter region, and forms an ohmic contact with the cathode. MOS turn-off structure for transporting holes from the P base region to the further P-type region is included. The MOS turn-off structure is of the normally-on type and can be biased into operation by a positive voltage which is readily derivable from the anode-to-cathode voltage of the device.

The foregoing thyristor may conveniently be referred to as an MOS turn-off thyristor ("MOSTOT").

Brief Description of the Drawings

While the specification concludes with claims particularly pointing out and distinctly claiming the subject matter which I regard as my invention, it is believed that the invention will be better understood from the following description, when considered in connection with the drawings, in which:

FIGURE 1 is a schematic illustration in cross-section of a portion of a MOSTOT in accordance with my invention; and

FIGURE 2 is a detail view of the P region shown in FIGURE 1; and

FIGURE 3 is a view similar to FIGURE 1 which depicts an alternative MOSTOT in accordance with a further embodiment of my invention.

-4-

## Description of the Preferred Embodiments

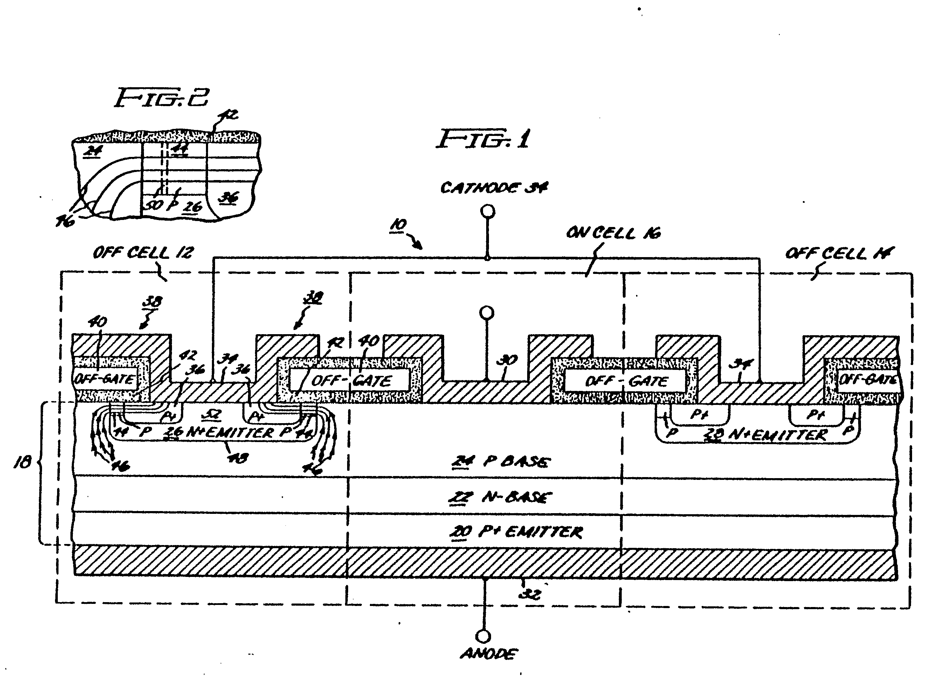

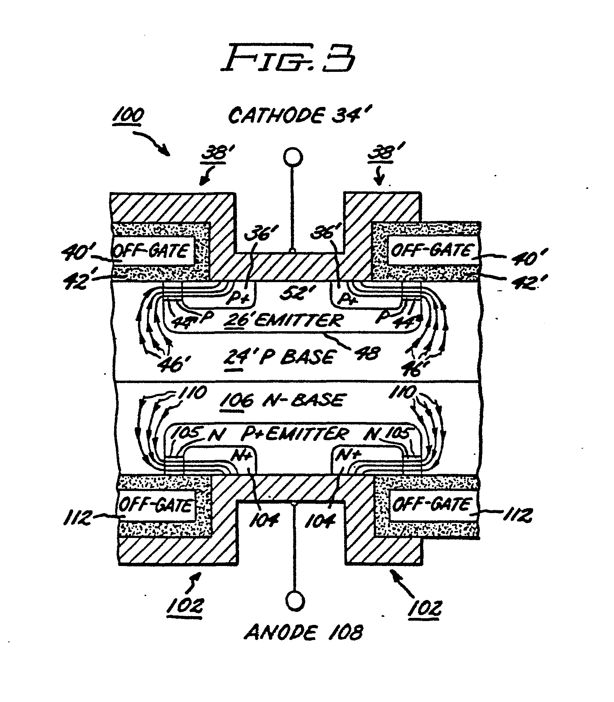

There is illustrated in FIGURE 1 a cross-section of a portion of MOSTOT 10, which includes "off" cells 12 and 14 (or cells having means for turning off the device) in accordance with my invention, as well as an "on" cell 16 (or cell having means for turning on the device). The complete MOSTOT 10 includes many off cells which are preferably identical in structure to each other, and many on cells, such as cell 16. Off cells 12 and 14 are each typically round or rectangular as viewed from above, while on cell 16 is typically rectangular, preferably with a narrow width/ (as shown in cross-section). MOSTOT 10 includes a body 18 of semiconductor material, preferably silicon. In the preferred embodiment, as illustrated, semiconductor body 18 includes a $P^+$ emitter region 20, an $N^-$ base region 22, a P base region 24, and $N^+$ emitter regions 26 and 28. The doping profile of semiconductor body 18, taken vertically through regions 20, 22, 24 and 26, is selected to yield good thyristor performance. By way of example, a suitable doping profile is illustrated in FIGURE 2(a) of S.M. Sze, Physics of Semiconductor Devices, New York: Wiley-Interscience(1969) at page 322. MOSTOT 10 further includes an anode 32, adjoining $P^+$ emitter region 20, and a cathode 34, adjoining $N^+$ emitter regions 24 and 26.

As will be apparent to those skilled in the art, MOSTOT 10 will turn on if P base region 24 is supplied with a sufficient level of hole current. This occurs through operation of on cell 16, which, per se, is known in the art. Cell 16 includes an on-gate 30, comprising, for example, metallization adjoining P base region 24. When on-gate 30 is biased with a positive voltage (with respect to cathode 34),hole current is supplied to P base region 24 via on-gate 30, and, if the level of this hole current is sufficient, cells adjacent to on-cell 16, starting with the immediately adjacent off-cells 12 and 16, are turned on. Typically, further on cells in MOSTOT 10 operate in cooperation with on cell 16 so as to more rapidly turn on MOSTOT 10. Advantageously, the voltage required to bias on-gate 30 for turning on MOSTOT 10 can be readily derived from the anode 32-to-cathode 34 voltage of MOSTOT 10, at least when MOSTOT 10 includes on cells of typical construction.

When turn-off of MOSTOT 10 is desired, the removal of sufficient hole current from P base region 24 will accomplish the task. Off cells 12 and 14 can be operated to remove hole current from P base region 24 and direct it to cathode 34. Since off cells 12 and 14 are suitably identical in structure to each other, the following description makes explicit reference only to off cell 12, for simplicity of description. As illustrated in FIGURE 1, the left side of off cell 12 is symmetrical with its right half. Portions of off cell 12 appearing in both halves of off cell 12 are numbered in each half for ease of understanding. Off cell 12 includes $P^+$ region 36, and MOS turn-off structure 38. $P^+$ region 36 adjoins $N^+$ emitter region 26, and has a high dopant concentration so as to form an ohmic contact with cathode 34. MOS turn-off structure 38 comprises a control electrode or off-gate 40, preferably comprising highly doped polysilicon or other conductive refractory material, an insulating layer 42, preferably an oxide of semiconductor material forming a sleeve around off-gate 40; and, P-type region 44 of semiconductor material.

_6-

Region 44 is overlaid by insulating layer 42 and connects $P^+$ region 36 to P base region 24. Accordingly, MOS turn-off structure 38 is of the normally-on or-conducting type; that is, with any bias voltage on turn-off gate 40 below a positive threshold value (e.g., zero volts), turn-off structure 38 is in an "on" or conducting state in which it is effective to transport holes from P base region 24 to $P^+$ region 36, and thence to cathode 34, along a distributed current path 46. However, when off-gate 40 is biased with a positive voltage in excess of a threshold value, MOS turn-off structure 38 changes to an "off" state in which P region 44 can no longer conduct holes in distributed current path 46, thereby removing an impediment to turn-on of MOSTOT 10.

The loss of ability of P region 44 to conduct hole current can be better appreciated by considering the detail view of P region 44 and surrounding structure as depicted in FIGURE 2. With off-gate 40 biased with a positive voltage in excess of a threshold level, a vertical slice or cross-section 50 of P region 44, extending from insulating layer 42 to $N^+$ emitter region 26 and forming a closed loop in off cell 12 so as to surround $P^+$ region 36, becomes depleted of holes so that the level of hole current in current path 46 drops to a negligible amount, such as zero. In its off state, off cell 12 can be turned on. Advantageously, the positive voltage used to bias off-gate 40 can be readily derived from the anode 32-to-cathode 34 voltage of MOSTOT 10. Such positive voltage can also be used to bias on-gate 30, although appropriate circuitry, such as a current-limiting resistor (not shown) should then be used to limit current flow to on-gate 30.

In order to achieve turn-off of MOSTOT 10 without having to rely upon commutation (i.e., reversal of the anode 32-to-cathode 34 voltage of MOSTOT 10), the electrical resistance to holes of distributed current path 46 must be low enough to prevent P-N junction 48, between P base region 24 and $N^+$ emitter region 26, from becoming forward biased due to hole current flow in current path 46, by more than about one-half of the energy bandgap voltage of the semiconductor material forming P-N junction 48 (i.e., typically about 1.0 volt in silicon). Additionally, corresponding limits would apply to the distributed current paths of all other off cells in MOSTOT 10.

One way to minimize the resistance of current path 46 is to increase the dopant concentration of P-type region 44 to enhance its conductivity. This, however, requires a higher voltage on off-gate 40 in order to deplete cross-section 50 of P-type region 44 of holes, resulting in an increased electric field in insulating layer 42. A limit on the net dopant concentration of cross-section 50 is established by the critical electric field in insulating layer 42 at which such layer "breaks down" or loses its dielectric capacity. It is desirable that the level of voltage on off-gate 40 required to deplete P-type region 44 of holes be below about 10 volts, so as to simplify the circuitry necessary to generate this voltage. By making insulating layer 42 thin, the value of such voltage as well as the value of the electric field in insulating layer 42, can be minimized. Insulating layer 42 should not be made too thin, however, in order to avoid manufacturing defects therein such as pin holes, and also to avoid an undesirably large capacitance for off-gate 40, which would increase the amount

-7-

- 8 -

of charge that must be supplied to off-gate 40 when it is being biased. A typical thickness of layer 42 might be in the range of .02 to .4 microns. Further design considerations concerning the resistance of a distributed current path 46 are discussed in the above-referenced application Serial No. 391,620.

MOSTOT 10 can be embodied in an alternative form in which distributed current paths of its off cells, such as current path 46 of cell 12, have resistances that are too high to permit turn-off of the alternative MOSTOT 10 solely as a result of current in such current paths. Rather, the alternative MOSTOT 10 must additionally be commutated off (i.e., by reversing the anode-to-cathode voltage of the device), although turn-off of the alternative MOSTOT 10 is much faster than the time required for commutation alone.

In fabricating MOSTOT 10, $P^+$ emitter region 20, $N^-$ base region 22, and P base region 24 are suitably fabricated using conventional techniques for making thyristors. MOS turn-off structure 38, along with $P^+$ region 36 and $N^+$ emitter regions 26 and 28, are suitably fabricated using conventional techniques for making field-effect transistors. P region 44 is suitably formed as described below.

P region 44 is preferably formed after $P^+$ region 36 has been formed. P region 44 is preferably formed by a blanket ion implanting which does not convert to P-type, portion 52 of $N^+$ emitter region 26, but does convert to P-type that portion of $N^+$ emitter region 26 designated 44.

The ion implanting to form P region 44 is preferably of the high energy type. This is to allow $P^+$ region 36 to be

- 9 -

conveniently formed by using off-gate 40 with insulating layer 42 thereon as part of a diffusion mask. Accordingly, ions to form P region 44 must pass through insulating layer 42. If, on the other hand, off-gate 40 were to be implemented as a metallic material, low energy ion implanting for forming P region 44, prior to the metallization for off-gate 40, would be suitable.

As discussed above, the dopant concentration of P region 44 should be high to minimize the resistance of current path 46. However, such dopant concentration must not be so high that cross-section 50 of P region 44 cannot be depleted of holes. A dopant concentration of about    impurity atoms per cubic centimeter would be suitable. The dopant concentration of P region 44 preferably does not counteract and thus reduce the N-type dopant concentration in $N^+$ emitter portion 52, which adjoins cathode 34, to such an extent that $N^+$ region 26 fails to form an ohmic contact with cathode 34. Otherwise, an extra processing step would be required to insure that some portion of $N^+$ emitter region 26 makes ohmic contact with cathode 34.

It is desirable that cross-section 50 can be depleted of holes with a biasing voltage on off-gate 40 limited to about 10 to 20 volts. If the required biasing voltage is found to be above this range, it can be lowered somewhat by at least one short diffusion drive of P region 44 which will increase its vertical depth by roughly 15 percent. This is accomplished by heating the thus-formed MOSTOT 10, with any metallization removed, to a temperature in the range of 1000 to 1200°C for a short period of time, such as    minutes. With the vertical depth of P region 44 increased, the net P-type dopant concentration of cross-section 50 is lowered due to the increase therein of N-type dopant from $N^+$ emitter region 26. A further technique of

-10-

insuring that P region 44 has the desired dopant concentration is to use a "trim" implant, or ion implanting of either N-type or P-type dopant of low concentration to trim or adjust the dopant concentration in P region 44.

Turning to FIGURE 3, an off cell of a MOSTOT 100 in accordance with a further embodiment of my invention is illustrated. The off cell of MOSTOT 100 is structurally identical to off cell 12 of MOSTOT 10 (Fig.1) with the exception that the off cell of MOSTOT 100 includes MOS turn-off structure 102 at the lower portion thereof, which is complementary to MOS turn-off structure 38' at the upper portion thereof; and $N^+$ region 104 and N region 105, which are respectively complementary to $P^+$ region 36' and P region 44' at the upper portion thereof. MOS turn-off structure 102 operates in a manner complementary to the operation of MOS turn-off structure 38', in that MOS structure 102 is effective to transport electrons from $N^-$ base region 106 to anode 108 via a distributed current path 110, whereas MOS turn-off structure 38' is effective to transport holes from P base region 24' to cathode 34'. Simultaneous operation in MOSTOT 100 of MOS turn-off structures 38' and 102 serves to increase the speed of turn-off of MOSTOT 100 compared to that of MOSTOT 10 (Fig.1). The required bias voltage on off-gate 112 of MOS turn-off structure 102 for terminating electron flow in current path 110 can be readily derived from the anode 108-to-cathode 34' voltage of MOSTOT 100.

A still further embodiment of my invention (not illustrated) comprises a MOSTOT which is structurally identical to MOSTOT 100 with the exception that it does not include MOS turn-off structure at its upper surface, such as MOS turn-off structure 38'.

-10-

- II -

The foregoing describes a form of thyristor including MOS turn-off structure whose control electrode can be biased with a voltage readily derivable from the anode-to-cathode voltage of the device. Additionally, both the MOS turn-off structure and a turn-on structure of the thyristor can be biased with a single voltage, at least where the MOS turn-off structure is formed at the upper portion of the device.

While the invention has been described with respect to specific embodiments, many modifications and substitutions will occur to those skilled in the art. For example, complementary thyristors can be fabricated in which P-type material is used in lieu of N-type material, and vice-versa. Further, thyristors having means for turning on other than the particular turn-on structure described above could be provided. Still further, while the MOSTOTs illustrated herein are of the diffused region-MOS(DMOS) type, MOSTOTs of the etched "V"-groove-MOS(VMOS) type could also be made. A description of a DMOS type device, as well as a description of a particular/of a DMOS version type device, is contained in D.Kahng, editor, Silicon Integrated Circuits-Part B, pages 209-211, which is incorporated herein by reference. Additionally, MOS turn-off structure as described herein embraces, as will be readily apparent to those skilled in the art, structure with a non-metallic conductive material, such as highly-doped polysilicon, used in lieu of metal, and with an insulating material other than an oxide of semiconductor material, used in lieu of such an oxide. It is,therefore, to be understood that the appended claims are intended to cover all such modifications and substitutions as fall within the true spirit and scope of the invention.

10229-RD-14244

THYRISTOR WITH TURN-OFF CAPABILITY

CLAIMS

1.  In a thyristor including a body of semiconductor material having first, second, third and fourth regions successively joined together and arranged in alternate conductivity types, and first and second electrodes respectively connected to said first and fourth regions, the improvement comprising:

    (a) a fifth region included in said body, being of the same conductivity type as said first region, and forming an ohmic contact with said second electrode; and

    (b) first normally-on MOS means for transporting majority carriers from said third region to said fifth region.

2.  The thyristor according to claim 1 wherein said first normally-on MOS means comprises:

    (a) a sixth region of same conductivity type as said fifth region included in said body and forming a connection between said third region and said fifth region; and

    (b) a control electrode spaced from said body by an insulating layer, said control electrode overlying said sixth region.

3.  The thyristor according to claim 2 wherein said conductivity type of said first region comprises P-conductivity type.

- 2 -

4.    The thyristor according to claim 3 wherein said semiconductor material comprises silicon.

5.    The thyristor according to claim 2 wherein said control electrode comprises conductive refractory material.

6.    The thyristor of claim 2 wherein said control electrode comprises highly-doped polysilicon.

7.    The thyristor according to claim 4 wherein said semiconductor body comprises a wafer and said first, second, third, and fourth regions each comprise a respective layer parallel to a major surface of said wafer.

8.    The thyristor according to claim 5 wherein said sixth region comprises an ion implanted region.

9.    The thyristor of claim 1 further comprising:

    (a) a further region included in said body, being of conductivity type opposite to that of said first region and forming an ohmic contact with said first electrode; and

    (b) second normally-on MOS means for transporting majority carriers from said second region to said further region.

10.    The thyristor according to claim 9 wherein said second normally-on MOS structure comprises:

    (a) a still further region of opposite conductivity type as said first region included in said body and forming a connection between said second region and said still further region; and

    (b) a control electrode spaced from said body by an insulating layer, said control electrode overlying said still further region.

FIG.2

FIG.1

CATHODE 34

10

ON CELL 16

OFF CELL 12

OFF CELL 14

24

42

44

50 P 26

36

16

38

40

32

42

R

40

36

34

36

30

34

OFF-GATE

OFF-GATE

OFF-GATE

OFF-GATE

44 P 26 N+ EMITTER P 44

P+

52

P+

P+

P+

P

28 N+ EMITTER

P

48

24 P BASE

18

16

16

22 N-BASE

20 P+ EMITTER

32

ANODE

10229-RD-14244

0106147

0106147

# FIG.3

CATHODE 34'

100

38'                    38'

OFF-GATE          OFF-GATE
40'                              40'
42'      36'      36'           42'
         P+   52'   P+
44 P    26'EMITTER    P 44
46'                        46'
24' P BASE     48

110    106 N-BASE    110
105 N  P+EMITTER  N 105
N+            N+

OFF-GATE          OFF-GATE
112                         112
104    104

102                    102

ANODE 108

# EUROPEAN SEARCH REPORT

## DOCUMENTS CONSIDERED TO BE RELEVANT

European Patent Office

| Category | Citation of document with indication, where appropriate, of relevant passages | Relevant to claim | CLASSIFICATION OF THE APPLICATION (Int. Cl. ³) |
|---|---|---|---|
| A | EP-A-0 028 799 (SIEMENS)<br>* Claims 1-3, 6; page 5, lines 19-30; figure 1 * | 1-3,7 | H 01 L 29/74<br>H 01 L 29/08<br>H 01 L 29/52 |
| A | EP-A-0 029 163 (SIEMENS)<br>* Claims 2-5, 11; page 4, line 31 - page 5, line 9; figure 1 * | 1-4,7 | |
| A | EP-A-0 030 274 (SIEMENS)<br>* Claim 1; page 5, line 33 - page 6, line 8; figures 1, 3 * | 1-3,7 | |
| A | DE-A-2 625 917 (ASEA)<br>* Pages 5, 6 * | | |
| A | US-A-4 199 774 (D. PLUMMER)<br>* Column 7, lines 17-49; figures 12, 13 * | | TECHNICAL FIELDS SEARCHED (Int. Cl. ³)<br><br>H 01 L 29/08<br>H 01 L 29/52<br>H 01 L 29/74 |

The present search report has been drawn up for all claims

| Place of search | Date of completion of the search | Examiner |
|---|---|---|
| BERLIN | 23-12-1983 | ROTHER A H J |